# EUROPÄISCHE PATENTSCHRIFT

(11) **EP 2 223 399 B1**
(45) Veröffentlichungstag und Bekanntmachung des Hinweises auf die Patenterteilung: **01.08.2018**
(21) Anmeldenummer: 08866552.6
(22) Anmeldetag: 15.12.2008
(51) Int. Cl.: H01S 5/042, H01S 5/22, H01S 5/40, H01S 5/16, H01S 5/223, H01S 3/08, H01S 5/20, H01S 5/10, H01S 5/30, H01S 5/024

(54) **KANTENEMITTIERENDER HALBLEITERLASERCHIP MIT ZUMINDEST EINER STROMBARRIERE**
EDGE-EMITTING SEMICONDUCTOR LASER CHIP HAVING AT LEAST ONE CURRENT BARRIER
PUCE LASER À SEMI-CONDUCTEUR À ÉMISSION PAR LA TRANCHE COMPRENANT AU MOINS UNE BARRIÈRE DE COURANT

(30) Priorität: 27.12.2007 DE 102007062789; 13.03.2008 DE 102008014093
(43) Veröffentlichungstag der Anmeldung: 01.09.2010
(73) Patentinhaber: OSRAM Opto Semiconductors GmbH, 93055 Regensburg (DE)
(72) Erfinder: KÖNIG, Harald, 93170 Bernhardswald (DE); LAUER, Christian, 93053 Regensburg (DE); MÜLLER, Martin, 93128 Regenstauf (DE); REUFER, Martin, 85296 Rohrbach (DE); MAYER, Bernd, 93059 Regensburg (DE)
(74) Vertreter: Epping - Hermann - Fischer
(86) Internationale Anmeldenummer: PCT/DE2008/002085
(87) Internationale Veröffentlichungsnummer: WO 2009/082995

(56) Entgegenhaltungen:
- WO-A-99/66614
- JP-A- 2007 311 682
- US-A- 5 793 521
- US-A- 6 104 738
- US-A- 6 148 013
- US-A1- 2003 031 222
- US-A1- 2006 007 976
- US-A1- 2007 127 532
- US-A1- 2007 165 685

## Beschreibung

Es wird ein kantenemittierender Halbleiterlaserchip angegeben.

Die Druckschrift US 6,947,464 B2 beschreibt einen kantenemittierenden Halbleiterlaserchip sowie ein Verfahren zur Herstellung eines kantenemittierenden Halbleiterlaserchips.

Die Druckschriften US 2003/0031222, WO 99/66614, US 5,793,521 und US 2007/0165685 beschreiben jeweils einen kantenemittierenden Halbleiterlaserchip.

Eine zu lösende Aufgabe besteht darin, einen kantenemittierenden Halbleiterlaserchip anzugeben, der geeignet ist, Laserstrahlung mit verringerter Strahldivergenz, insbesondere in der slow-axis Richtung, zu erzeugen. Ein solcher erfindungsgemäßer kantenemittierender Halbleiterlaserchip ist in Anspruch 1 definiert. Weitere Ausführungsformen werden in den abhängigen Ansprüchen definiert. Gemäß der Erfindung umfasst der kantenemittierende Halbleiterlaserchip zumindest einen Kontaktstreifen. Der Kontaktstreifen des Halbleiterlaserchips ist zur Injektion von Strom in den Halbleiterlaserchip vorgesehen. Der Kontaktstreifen ist beispielsweise durch eine Metallisierung auf einer Außenfläche des Halbleiterlaserchips gebildet. Der Kontaktstreifen weist dabei eine Breite B auf.

Gemäß zumindest einer Ausführungsform des kantenemittierenden Halbleiterlaserchips umfasst der kantenemittierende Halbleiterlaserchip eine aktive Zone. Im Betrieb des Halbleiterlaserchips wird in der aktiven Zone elektromagnetische Strahlung erzeugt. Die aktive Zone enthält beispielsweise einen oder mehrere Quantentopfstrukturen, welche bei Injektion von elektrischem Strom in die aktive Zone mittels stimulierter Rekombination optische Verstärkung bereitstellen.

Die Bezeichnung Quantentopfstruktur umfasst insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Gemäß zumindest einer Ausführungsform des kantenemittierenden Halbleiterlaserchips umfasst der kantenemittierende Halbleiterlaserchip zumindest zwei Strombarrieren. Die Strombarrieren verhindern eine laterale Stromaufweitung, sodass mittels eines Kontaktstreifens eingeprägter elektrischer Strom sich nicht derart aufweitet, dass die gesamte aktive Zone bestromt wird, sondern mit Hilfe der Strombarrieren nur ein bestimmter vorgebbarer Ausschnitt der aktiven Zone mit Strom beaufschlagt wird. Die Strombarrieren verhindern dazu zum Beispiel eine unkontrollierte Aufweitung des Stroms in den Halbleiterschichten, welche zwischen dem Kontaktstreifen und der aktiven Zone angeordnet sind. Die Stromaufweitung wird durch die Strombarrieren begrenzt.

Die Strombarrieren sind vorzugsweise auf unterschiedlichen Seiten des Kontaktstreifens angeordnet und erstrecken sich längs des Kontaktstreifens. Weist der kantenemittierende Halbleiterlaserchip mehr als einen Kontaktstreifen auf, so sind vorzugsweise jedem Kontaktstreifen zumindest zwei Strombarrieren zugeordnet, welche sich längs des Kontaktstreifens erstrecken. Es ist dabei auch möglich, dass sich zwischen zwei Kontaktstreifen genau eine Stormbarriere befindet. Die Strombarrieren müssen sich dabei jedoch nicht über die gesamte Länge des Kontaktstreifens erstrecken.

Gemäß zumindest einer Ausführungsform des kantenemittierenden Halbleiterlaserchips ist der größte Abstand V zwischen zumindest einer der Strombarrieren und dem Kontaktstreifen dabei derart gewählt, dass das Verhältnis von größtem Abstand V zur Breite B des Kontaktstreifens V/B > 1,0 ist. Vorzugsweise ist der größte Abstand V zwischen jeder der beiden Strombarrieren und dem Kontaktstreifen dabei derart gewählt, dass das Verhältnis von größtem Abstand V zur Breite B des Kontaktstreifens V/B > 1,0 ist. Der Abstand wird dabei von der Außenkante des Kontaktstreifens zur Innenkante der Strombarriere senkrecht zur Längsmittelachse gemessen. Der Abstand wird bevorzugt in der aktiven Zone bestimmt. Das heißt, der Abstand wird beispielsweise in der Ebene bestimmt, in der sich die dem Kontaktstreifen zugewandte Oberfläche der aktiven Zone befindet. Der Abstand wird dann zwischen einer Projektion des Kontaktstreifens in diese Ebene und der Innenkante der Stormbarriere bestimmt.

Gemäß zumindest einer Ausführungsform des kantenemittierenden Halbleiterlaserchips umfasst der kantenemittierende Halbleiterlaserchip zumindest einen Kontaktstreifen, wobei der Kontaktstreifen eine Breite B aufweist, eine aktive Zone, in der im Betrieb des Halbleiterlaserchips elektromagnetische Strahlung erzeugt wird, zumindest zwei Strombarrieren, die auf unterschiedlichen Seiten des Kontaktstreifens angeordnet sind und sich längs des Kontaktstreifens erstrecken, wobei der Abstand zwischen jeder der beiden Strombarrieren und dem Kontaktstreifen derart gewählt ist, dass das Verhältnis von größtem Abstand V zur Breite B V/B > 1,0 ist.

Gemäß zumindest einer Ausführungsform des kantenemittierenden Halbleiterlaserchips ist das Verhältnis vom größten Abstand V zur Breite B V/B > 1,2.

Gemäß zumindest einer Ausführungsform des kantenemittierenden Halbleiterlaserchips ist das Verhältnis vom größten Abstand V zur Breite B V/B > 1,5.

Gemäß zumindest einer Ausführungsform des kantenemittierenden Halbleiterlaserchips befindet sich der größte Abstand V an der Seite des Halbleiterlaserchips, an der sich eine Auskoppelfacette des Halbleiterlaserchips befindet. Dabei ist es möglich, dass der Abstand zumindest einer der Strombarrieren vom Kontaktstreifen mit abnehmendem Abstand zu der Seite, an der sich die Auskoppelfacette des Halbleiterlaserchips befindet, zunimmt. Das heißt, die Strombarriere verläuft beispielsweise längs des Kontaktstreifens, wobei sich ihr Abstand zum Kontaktstreifen mit abnehmendem Abstand zu der Seite, an der sich eine Auskoppelfacette des Halbleiterlaserchips befindet, vergrößert.

Gemäß zumindest einer Ausführungsform des kantenemittierenden Halbleiterlaserchips sind je zwei Strombarrieren achsensymmetrisch zur Längsmittelachse eines Kontaktstreifens angeordnet. Die Längsmittelachse ist dabei jene Achse, die sich von der Seite des Halbleiterlaserchips, an der sich die Auskoppelfacette befindet, zu der dieser Seite gegenüberliegenden Seite des Halbleiterlaserchips erstreckt, wobei die Achse in der Mitte des Kontaktstreifens angeordnet ist. Die Längsmittelachse kann dabei eine Symmetrieachse des Kontaktstreifens bilden. Die Strombarrieren sind dann an zwei unterschiedlichen Seiten des Kontaktstreifens achsensymmetrisch zur Längsmittelachse angeordnet. "Achsensymmetrisch" bedeutet dabei, dass die Strombarrieren im Rahmen der Herstellungstoleranz achsensymmetrisch angeordnet sind. Dem Fachmann ist dabei klar, dass eine im mathematischen Sinn strenge Achsensymmetrie bei realen Halbleiterlaserchips nicht erreicht werden kann.

Gemäß zumindest einer Ausführungsform des kantenemittierenden Halbleiterlaserchips ist die Form der Strombarrieren in einer Ebene parallel zur Erstreckungsebene des Kontaktstreifens an eine im Betrieb des Halbleiterlaserchips in diesem induzierte thermische Linse angepasst. Die Erstreckungsebene des Kontaktstreifens ist diejenige Ebene, in welche sich der Kontaktstreifen erstreckt. Sie ist beispielsweise parallel zu der Oberfläche des Halbleiterlaserchips, auf welche der Kontaktstreifen aufgebracht ist. Dies kann beispielsweise die Oberseite des Halbleiterlaserchips sein.

Bei Betrieb des kantenemittierenden Halbleiterlaserchips entsteht Verlustwärme. Diese Verlustwärme erzeugt Temperaturgradienten im Halbleiterlaserchip. Dabei bildet sich eine inhomogene Temperaturverteilung im Halbleiterlaserchip aus, derart, dass die Temperatur dort, wo das im Betrieb erzeugte Laserlicht aus dem Halbleiterlaserchip ausgekoppelt wird - an der Auskoppelfacette - ein lokales Maximum aufweist. Der Brechungsindex des Halbleitermaterials, aus welchem der kantenemittierende Halbleiterlaserchip gebildet ist, ist temperaturabhängig, dergestalt, dass der Brechungsindex mit steigender Temperatur zunimmt. Daher entsteht im Bereich der Auskoppelfacette eine thermische Sammellinse, welche die Phasenfront der im Resonator umlaufenden elektromagnetischen Strahlung verzerrt. Die Form der Strombarrieren ist dabei so gewählt, dass sie in einer Ebene parallel zur Erstreckungsebene des Kontaktstreifens der Form der thermischen Linse folgt. Auf diese Weise kann die Strombarriere die thermische Linse beeinflussen. Das heißt, in Richtung der Auskoppelfacette erhöht sich der Abstand von Strombarriere zum Kontaktstreifen. Dadurch wird die Heizleistung im Betrieb des Halbleiterlaserchips im Bereich der Auskoppelfacette auf einen größeren Raum verteilt, die Stromdichte nimmt ab. Dadurch wird der Temperaturgradient im Halbleitermaterial kleiner und der thermische Linsen-Effekt nimmt ab.

Gemäß zumindest einer Ausführungsform des kantenemittierenden Halbleiterlaserchips ist der Verlauf zumindest einer der Strombarrieren zumindest stellenweise in einer Ebene parallel zur Erstreckungsebene des Kontaktstreifens stufenartig. Das heißt, die Strombarriere verläuft nicht kontinuierlich, sondern sie weist Sprünge im Abstand zum Kontaktstreifen auf, welche ihr einen stufenartigen Verlauf verleihen.

Gemäß zumindest einer Ausführungsform des kantenemittierenden Halbleiterlaserchips weist der Halbleiterlaserchip zumindest zwei Kontaktstreifen auf. Über jeden der Kontaktstreifen des Halbleiterlaserchips wird elektrischer Strom in die aktive Zone des Halbleiterlaserchips injiziert. Pro Kontaktstreifen wird im kantenemittierenden Halbleiterlaserchip ein räumlich getrennter Laserstrahl erzeugt, sodass die Anzahl der Laserstrahlen der Zahl der Kontaktstreifen entspricht. Der kantenemittierende Halbleiterlaserchip weist dann eine der Anzahl der Kontaktstreifen entsprechende Anzahl von Emittern auf, wobei sich die Austrittsfläche eines jeden Emitters an der Auskoppelfacette des Halbleiterlaserchips befindet.

Gemäß zumindest einer Ausführungsform des kantenemittierenden Halbleiterlaserchips umfasst der kantenemittierende Halbleiterlaserchip ferner zumindest einen Kontaktstreifen, der strukturiert ist. Das heißt, der Kontaktstreifen ist nicht homogen, beispielsweise als eine Metallschicht gleichmäßiger Breite und/oder Dicke ausgebildet, sondern der Kontaktstreifen weist Strukturen auf.

Der Kontaktstreifen ist dabei derart strukturiert, dass eine Ladungsträgerinjektion in die aktive Zone zu einer Seite des Halbleiterlaserchips hin abnimmt, an der sich die Auskoppelfacette des Halbleiterlaserchips befindet.

Mit anderen Worten erstreckt sich der Kontaktstreifen beispielsweise auf der Oberseite des Halbleiterlaserchips in Emissionsrichtung der vom kantenemittierenden Halbleiterlaserchip im Betrieb erzeugten Laserstrahlung. Der Kontaktstreifen erstreckt sich beispielsweise von der der Auskoppelfacette abgewandten Seite des kantenemittierenden Halbleiterlaserchips zu der Seite des Halbleiterlaserchips, an welcher sich die Auskoppelfacette des Halbleiterlaserchips befindet. Der Kontaktstreifen ist dabei derart strukturiert, dass in Bereichen des Kontaktstreifens in der Nähe der Auskoppelfacette weniger Strom in die aktive Zone injiziert wird als in Bereichen des Kontaktstreifens, welche weit von der Auskoppelfacette entfernt sind. Die Ladungsträgerinjektion in die aktive Zone nimmt daher zu der Seite des Halbleiterlaserchips hin ab, an welcher sich die Auskoppelfacette des Halbleiterlaserchips befindet.

Gemäß zumindest einer Ausführungsform des kantenemittierenden Halbleiterlaserchips umfasst der Halbleiterlaserchip eine aktive Zone, in der im Betrieb des Halbleiterlaserchips elektromagnetische Strahlung erzeugt wird. Ferner umfasst der kantenemittierende Halbleiterlaserchip zumindest einen strukturierten Kontaktstreifen, wobei der Kontaktstreifen derart strukturiert ist, dass eine Ladungsträgerinjektion in die aktive Zone zu einer Seite des Halbleiterlaserchips hin abnimmt, an der sich eine Auskoppelfacette des Halbleiterlaserchips befindet.

Gemäß zumindest einer Ausführungsform des kantenemittierenden Halbleiterlaserchips ist der Kontaktstreifen in Bereiche hoher und Bereiche niedriger Ladungsträgerinjektion strukturiert. Das heißt, der Kontaktstreifen weist Bereiche auf, aus denen wenig Strom in die aktive Zone injiziert wird. Dabei ist es möglich, dass aus diesen Bereichen gar kein Strom in die aktive Zone injiziert wird. Diese Bereiche des Kontaktstreifens sind die Bereiche niedriger Ladungsträgerinjektion. Darüber hinaus weist der Kontaktstreifen Bereiche auf, aus denen ein höherer Strom in die aktive Zone injiziert wird. Aus diesen Bereichen wird die aktive Zone beispielsweise ungefähr mit der normalen Betriebsstromdichte des Halbleiterlaserchips bestromt. Diese Bereiche sind die Bereiche hoher Ladungsträgerinjektion.

Gemäß zumindest einer Ausführungsform des kantenemittierenden Halbleiterlaserchips ist der Kontaktstreifen in einer Richtung längs zur Längsmittelachse des Kontaktstreifens in Bereiche hoher und Bereiche niedriger Ladungsträgerinjektion strukturiert. Beispielsweise verläuft der Kontaktstreifen von der Seite des Halbleiterlaserchips, welche der Auskoppelfacette abgewandt ist, zu der Seite des Halbleiterlaserchips, an der sich die Auskoppelfacette befindet. Beispielsweise ist die Längsmittelachse parallel zur Emissionsrichtung der vom Halbleiterlaserchip erzeugten Laserstrahlung.

Überfährt man nun den Kontaktstreifen längs der Längsmittelachse, so ist der Kontaktstreifen in Bereiche hoher und Bereiche niedriger Ladungsträgerinjektion strukturiert. Die Bereiche können dabei beispielsweise jeweils eine rechteckige oder anders geformte Grundfläche aufweisen. Die Bereiche können auf diese Weise zum Beispiel durch Streifen gebildet sein, welche die gleiche Breite wie der Kontaktstreifen aufweisen.

Gemäß zumindest einer Ausführungsform des kantenemittierenden Halbleiterlaserchips nimmt der Flächenanteil der Bereiche hoher Ladungsträgerinjektion mit kleiner werdendem Abstand zu der Seite des Halbleiterlaserchips hin ab, an der sich eine Auskoppelfacette des Halbleiterlaserchips befindet. Auf diese Weise nimmt die Ladungsträgerinjektion in die aktive Zone zu der Seite des Halbleiterlaserchips hin ab, an der sich die Auskoppelfacette des Halbleiterlaserchips befindet. Der Flächenanteil bezieht sich beispielsweise auf die Gesamtfläche des Kontaktstreifens.

Gemäß zumindest einer Ausführungsform des kantenemittierenden Halbleiterlaserchips ist der Kontaktstreifen in einer Richtung quer zur Längsmittelachse des Kontaktstreifens in Bereiche hoher und Bereiche niedriger Ladungsträgerinjektion strukturiert. Das heißt, überfährt man den Kontaktstreifen in einer Richtung quer zur Richtung der Längsmittelachse, das heißt beispielsweise senkrecht zur Längsmittelachse, so überfährt man Bereiche hoher und niedriger Ladungsträgerinjektion.

Gemäß zumindest einer Ausführungsform des kantenemittierenden Halbleiterlaserchips nimmt der Flächenanteil der Bereiche hoher Ladungsträgerinjektion mit kleiner werdendem Abstand zur Längsmittelachse hin ab. Das bedeutet, in der Mitte des Kontaktstreifens wird auf diese Weise wenig oder gar kein elektrischer Strom in die aktive Zone injiziert. In den Außenbereichen des Kontaktstreifens wird hingegen mehr Strom als in der Mitte des Kontaktstreifens in die aktive Zone injiziert. Bevorzugt befindet sich ein derart in Richtung quer zur Längsmittelachse strukturierter Abschnitt des Kontaktstreifens in der Nähe der Seite des Halbleiterlaserchips, an der sich die Auskoppelfacette des Halbleiterlaserchips befindet. In anderen Abschnitten des Kontaktstreifens, welche weiter von der Auskoppelfacette entfernt liegen, kann der Kontaktstreifen dann beispielsweise unstrukturiert sein, sodass dort ein hoher Strom in die aktive Zone injiziert wird.

Gemäß zumindest einer Ausführungsform des kantenemittierenden Halbleiterlaserchips nimmt der Flächenanteil der Bereiche hoher Ladungsträgerinjektion mit kleiner werdendem Abstand zur Längsmittelachse sowie mit kleiner werdendem Abstand zu der Seite des Halbleiterlaserchips hin ab, an der sich eine Auskoppelfacette des Halbleiterlaserchips befindet. Dies kann beispielsweise dadurch erreicht sein, dass die Bereiche hoher Ladungsträgerinjektion durch Streifen gebildet sind, welche sich längs der Längsmittelachse des Kontaktstreifens erstrecken und sich in Richtung der Auskoppelfacette hin verjüngen.

Gemäß zumindest einer Ausführungsform des kantenemittierenden Halbleiterlaserchips ist der Kontaktstreifen in einer Richtung quer zur Längsmittelachse des Kontaktstreifens sowie in einer Richtung parallel zur Längsmittelachse des Kontaktstreifens in Bereiche hoher und Bereiche niedriger Ladungsträgerinjektion strukturiert. Dies kann beispielsweise dadurch erreicht sein, dass der Kontaktstreifen in Bereiche hoher und niedriger Ladungsträgerinjektion strukturiert ist, welche sich längs und quer zur Längsmittelachse des Kontaktstreifens erstrecken.

Gemäß zumindest einer Ausführungsform des kantenemittierenden Halbleiterlaserchips besteht der Kontaktstreifen in den Bereichen hoher Ladungsträgerinjektion aus einem ersten Material und in Bereichen niedriger Ladungsträgerinjektion aus einem zweiten Material. Dabei ist das erste Material derart gewählt, dass sein Übergangswiderstand zum Halbleitermaterial des kantenemittierenden Halbleiterlaserchips, auf das der Kontaktstreifen aufgebracht ist, kleiner gewählt ist als der Übergangswiderstand des zweiten Materials. Auf diese Weise ist eine Strukturierung des Kontaktstreifens in Bereiche hoher und niedriger Ladungsträgerinjektion realisiert. Beispielsweise enthalten oder bestehen das erste und das zweite Material aus ersten und zweiten Metallen. Dadurch weisen sowohl die Bereiche hoher als auch die Bereiche niedriger Ladungsträgerinjektion in etwa die gleiche Wärmeleitfähigkeit auf, da sie beide jeweils aus Metallen bestehen oder solche enthalten. Folglich variiert die Wärmeleitfähigkeit räumlich nicht und damit der Wärmeabtransport aus dem Halbleiterlaserchip über den Kontaktstreifen kaum oder gar nicht.

Ferner ist es möglich, dass der Kontaktstreifen dritte, vierte, und so weiter weitere Bereiche aufweist, welche aus dritten, vierten, und so weiter weiteren Materialien gebildet sind. Die Höhe der Ladungsträgerinjektion aus diesen Bereichen kann dann zwischen der Höhe der Ladungsträgerinjektion aus den Bereichen mit dem ersten Metall und der Höhe der Ladungsträgerinjektion mit den Bereichen des zweiten Metalls liegen. Das bedeutet, der Kontaktstreifen weist dann Bereiche hoher, Bereiche niedriger und Bereiche auf, bei denen die Ladungsträgerinjektion zwischen diesen beiden Extremwerten liegt. Auf diese Weise ist eine weitere, feinere Strukturierung und damit eine noch genauere Einstellung der Ladungsträgerinjektion in die aktive Zone ermöglicht.

Gemäß zumindest einer Ausführungsform befinden sich sowohl auf der Ober- als auch der Unterseite des kantenemittierenden Halbleiterlaserchips Kontaktstreifen, die in der hier beschriebenen Weise strukturiert sind.

Im Folgenden wird der hier beschriebene kantenemittierende Halbleiterlaserchip anhand von Ausführungsbeispielen und den dazugehörigen Figuren näher erläutert.
- Figur 1: zeigt aufgetragene Messwerte der Strahldivergenz in Winkelgrad gegen die Ausgangsleistung eines kantenemittierenden Halbleiterlaserchips.
- Figur 2: zeigt anhand einer schematischen Draufsicht die Einkopplung von Laserstrahlung in eine Faseroptik.
- Figur 3A: zeigt in einer schematischen perspektivischen Darstellung eine simulierte Temperaturverteilung in einem kantenemittierenden Halbleiterlaserchip.
- Figur 3B: zeigt einen hier beschriebenen kantenemittierenden Halbleiterlaserchip in einer schematischen Schnittdarstellung.
- Figur 4A: zeigt eine schematische Darstellung der Effizienz kantenemittierender Halbleiterlaserchips.
- Figur 4B: zeigt eine schematische Darstellung der horizontalen Strahldivergenz für kantenemittierende Halbleiterlaserchips.
- Figuren 5 bis 27: zeigen schematische Draufsichten von Ausführungsbeispielen hier beschriebener kantenemittierender Halbleiterlaserchips mit unterschiedlichen Ausgestaltungen der Strombarrieren.
- Figuren 28 bis 32: zeigen schematische Draufsichten von Ausführungsbeispielen hier beschriebener kantenemittierender Halbleiterlaserchips mit unterschiedlichen Ausgestaltungen des Kontaktstreifen.
- Figuren 33A und 33B: zeigen eine weitere Möglichkeit zur Strukturierung der Ladungsträgerinjektion anhand einer schematischen Schnittdarstellung.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

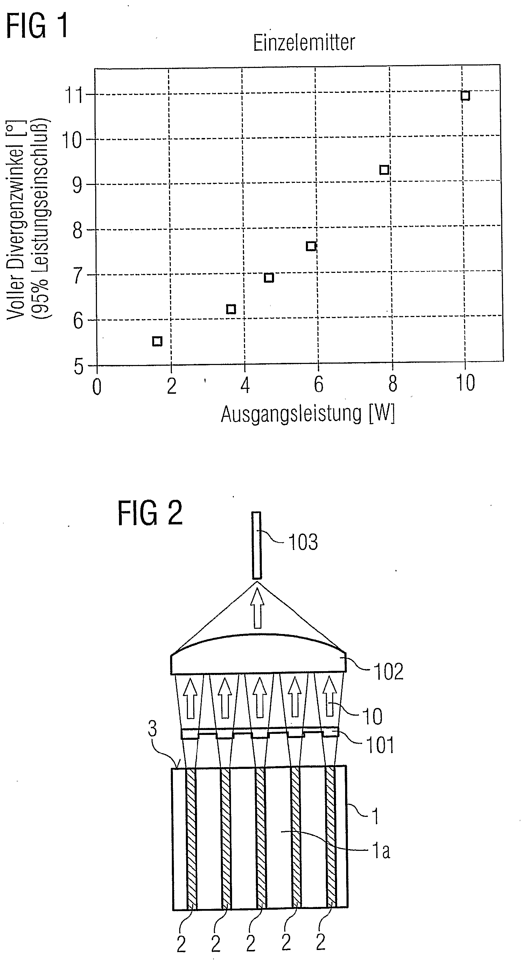

Der technische Fortschritt bei der Realisierung von Faserlasern und fasergekoppelten Lasern, die hervorragende Strahlqualität und hohe erreichbare Ausgangsleistungen ermöglichen, erlaubt zum Beispiel ihren Einsatz in neuen industriellen Anwendungen wie dem "Remote"-Schweißen. Als Pumplichtquelle werden üblicherweise kantenemittierende Halbleiterlaserdioden verwendet. Sie bieten einen sehr hohen Wirkungsgrad bei der Umwandlung der elektrisch aufgewendeten Leistung in nutzbare Strahlungsleistung bei gleichzeitig hoher optischer Ausgangsleistung. Andererseits zeigen sie jedoch eine starke Elliptizität des Fernfeldes. Eine effiziente Einkopplung der Laserstrahlung in den runden Faserquerschnitt einer Faseroptik 103 ist nur mit Hilfe teurer und aufwändig zu justierender Mikrooptiken 101 zu erreichen (siehe dazu auch die Figur 2). Eine Vereinfachung und Verbesserung der Faserkopplung der Laserdioden würde zu kostengünstigeren und zuverlässigeren Lasersystemen führen. Der Justageaufwand der Mikrooptiken verringert sich drastisch, wenn die Strahldivergenz zumindest in der ohnehin schmäleren horizontalen Richtung - die so genannte slow axis Richtung - kleiner wäre und der Strahl für effiziente Faserkopplung nur in der vertikalen Richtung - das heißt in der Richtung senkrecht zur Ebene, in der beispielsweise die Oberseite 1a des Halbleiterlaserchips liegt - stark transformiert werden muss.

Die Figur 1 zeigt aufgetragene Messwerte der Strahldivergenz in Winkelgrad gegen die Ausgangsleistung eines kantenemittierenden Halbleiterlaserchips. Dabei wurde die Strahldivergenz bei 95 % Leistungseinschluss bestimmt. Die Strahldivergenz wurde dabei in horizontaler Richtung (slow axis Richtung), das heißt in einer Ebene, die parallel zur Oberseite 1a (vergleiche dazu auch Figur 2) verläuft, bestimmt. "95 % Leistungseinschluss" bedeutet, dass für die Bestimmung der Strahldivergenz nur derjenige Bereich des Laserstrahls beachtet wurde, der 95 % der Ausgangsleistung einschließt.

Wie aus der Figur ersichtlich, wächst die horizontale Strahldivergenz mit steigender Ausgangsleistung des Lasers stark an. Dies erschwert den oben beschriebenen Einsatz des kantenemittierenden Halbleiterlaserchips für hohe Lichtleistungen, da die bevorzugt verwendeten kleinen Mikrooptiken 101 dann seitlich überstrahlt werden können und Licht verloren geht.

Die Figur 2 zeigt anhand einer schematischen Draufsicht die Einkopplung von Laserstrahlung 10, welche durch einen kantenemittierenden Halbleiterlaserchip 1 erzeugt wird, in eine Faseroptik 103. Die Figur 2 zeigt dabei einen kantenemittierenden Halbleiterlaserchip 1, welcher als Laserbarren mit fünf Einzelemittern ausgebildet ist. Der kantenemittierende Halbleiterlaserchip weist dafür an seiner Oberseite 1a fünf Kontaktstreifen 2 auf. An der Auskoppelfacette 3 werden fünf Laserstrahlen 10 ausgekoppelt, welche zunächst durch eine Mikrooptik 101 treten. Durch ein weiteres optisches Element 102, das beispielsweise eine Sammellinse ist, wird die Laserstrahlung zusammengeführt und in die Faseroptik 103 eingekoppelt.

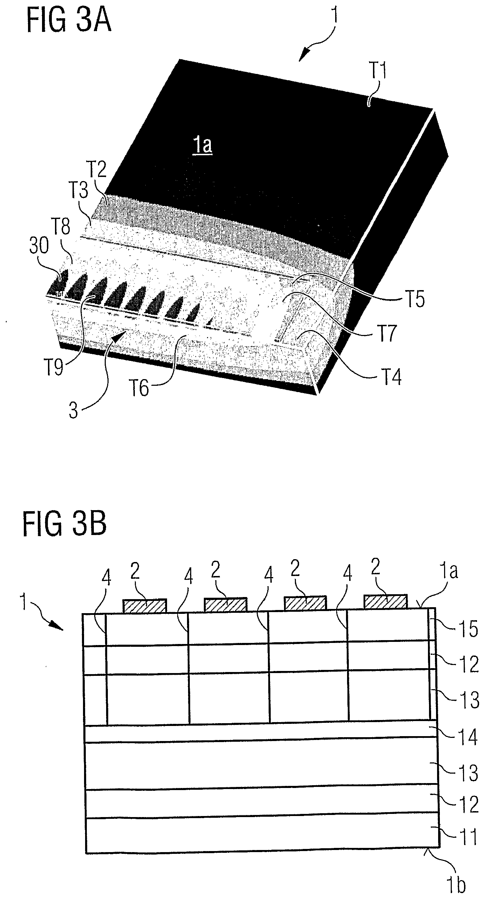

Die Figur 3A zeigt in einer schematischen perspektivischen Darstellung eine simulierte Temperaturverteilung in einem kantenemittierenden Halbleiterlaserchip 1, welcher als Laserbarren mit 24 Einzelemittern ausgeführt ist. Aus Symmetriegründen ist in der Darstellung nur der halbe Barren mit zwölf Emittern gezeigt. Die linke Kante in der Figur 3A entspricht der Mitte des Laserbarrens. Die dunklen Stellen in der Figur 3A symbolisieren Bereiche 30 hoher Temperatur T9. Die Bezugszeichen T1 bis T9 markieren Temperaturbereiche, wobei T1 den Bereich geringster Temperatur und T9 den Bereich höchster Temperatur kennzeichnet.

Die hohe Verlustleistungsdichte in hochleistungsfähigen kantenemittierenden Halbleiterlaserchips erzeugt einen Temperaturgradienten im Halbleiterlaserchip. Wie aus Figur 3A ersichtlich, bildet sich bei hohen Ausgangsleistungen von mehreren Watt und schmalen Streifenbreiten der einzelnen Emitter des kantenemittierenden Halbleiterlaserchips 1 eine inhomogene Temperaturverteilung im Resonator des kantenemittierenden Halbleiterlaserchips 1 aus. Dabei werden lokale Maxima der Temperatur T9 - die Bereiche hoher Temperatur 30 - in der Mitte der Auskoppelfacette 3 jedes einzelnen Emitters festgestellt. Dies ist auch bei kantenemittierenden Halbleiterlaserchips mit mehr oder weniger Emittern als beim Laser in der Figur 3A oder auch bei Lasern mit nur einem einzigen Emitter der Fall. Da der Brechungsindex des Halbleitermaterials, aus dem der Halbleiterlaserchip 1 gebildet ist, temperaturabhängig ist, entsteht in jedem Emitter eine thermische Sammellinse, welche die Phasenfront des im Resonator propagierenden Laserlichts verzerrt. Dadurch wirkt das Fernfeld des Lasers in horizontaler (slow axis) Richtung gegenüber dem unverzerrten Fall aufgeweitet. Bei steigender Ausgangsleistung beziehungsweise steigendem Pumpstrom steigt damit die Strahldivergenz wegen der mit der Verlustleistung stärker werdenden Phasenfrontverzerrung an (vergleiche dazu auch Figur 1).

Die maximal erreichte Temperatur und damit die Stärke der thermischen Linse steigt mit der im Halbleiterlaserchip 1 erzeugten elektrischen Verlustleistung. Laser mit höherer Effizienz erzeugen bei gleicher optischer Ausgangsleistung weniger Verlustleistung im Halbleiterlaserchip und zeigen im Allgemeinen geringere horizontale Strahldivergenzen.

Die Figur 3B zeigt einen hier beschriebenen kantenemittierenden Halbleiterlaserchip 1 in einer schematischen Schnittdarstellung. Der kantenemittierende Halbleiterlaserchip kann in unterschiedlichen Materialsystemen gefertigt sein. Beispielsweise handelt es sich um einen Halbleiterlaserchip, der auf einem der folgenden Halbleitermaterialien basiert: GaP, GaAsP, GaAs, GaAlAs, InGaAsP, GaN, InGaN, AlGaInAsSb. Darüber hinaus sind auch weitere Halbleitermaterialien aus den III-V oder den II-VI Halbleitersystemen denkbar. Bevorzugt basiert der Halbleiterchip beispielsweise auf dem AlGaInAs Materialsystem.

Bei dem kantenemittierenden Halbleiterlaserchip 1 handelt es sich beispielsweise um einen Diodenlaserbarren mit einer Vielzahl von Emittern, zum Beispiel mit vier bis sechs Emittern, welcher eine Resonatorlänge größer gleich 100µm, zum Beispiel zwischen 3 und 6 mm aufweist. Die Breite der von den einzelnen Emittern emittierten Laserstrahlung beträgt vorzugsweise zwischen 50 µm und 150 µm. Der kantenemittierende Halbleiterlaserchip 1 kann beispielsweise Laserstrahlung mit einer Zentralwellenlänge von 915 nm oder 976 nm erzeugen. Allerdings ist in Abhängigkeit vom verwendeten Halbleitermaterial auch die Erzeugung von kurz- oder längerwelligerem Laserlicht möglich. Zwischen den Kontaktstreifen 2 können sich Strombarrieren 4, welche die Stromeinprägung in die aktive Zone 14 in Richtungen parallel zur Emissionsrichtung des Halbleiterlaserchips 1 beschränken, befinden. Dabei ist es auch möglich, dass sich zwischen je zwei Kontaktstreifen zwei oder mehr Strombarrieren 4 befinden.

Der Halbleiterlaserchip 1 umfasst ein Substrat 11, bei dem es sich beispielsweise um ein Wachstumssubstrat handeln kann und das eine p-Kontaktschicht bilden kann. Ferner umfasst der kantenemittierende Halbleiterlaserchip 1 eine aktive Zone 14, welche zur Erzeugung elektromagnetischer Strahlung vorgesehen ist. Die aktive Zone 14 ist in Wellenführungsschichten 13 eingebettet, die einen höheren Bandabstand und einen geringeren Brechungsindex als die aktive Zone 14 aufweisen. An die Wellenführungsschichten grenzt jeweils eine Überzugsschicht 12, welche einen höheren Bandabstand und einen geringeren Brechungsindex als die Wellenführungsschichten 13 aufweist. Auf der dem Substrat 11 abgewandten Seite des Halbleiterlaserchips 1 befindet sich auf der Überzugsschicht 12 eine abschließende Kontaktschicht 15. Auf der Kontaktschicht 15 befinden sich Kontaktstreifen 2, über welche elektrischer Strom in die aktive Zone 14 injiziert werden kann. Die Breite der Kontaktstreifen 2 beträgt vorzugsweise zwischen 10 µm und mehreren 100 µm. Die Stormbarrieren 4 können sich dabei, wie in der Figur gezeigt, bis zur aktiven Zone 14 oder auch bis in das Substrat 11 erstrecken.

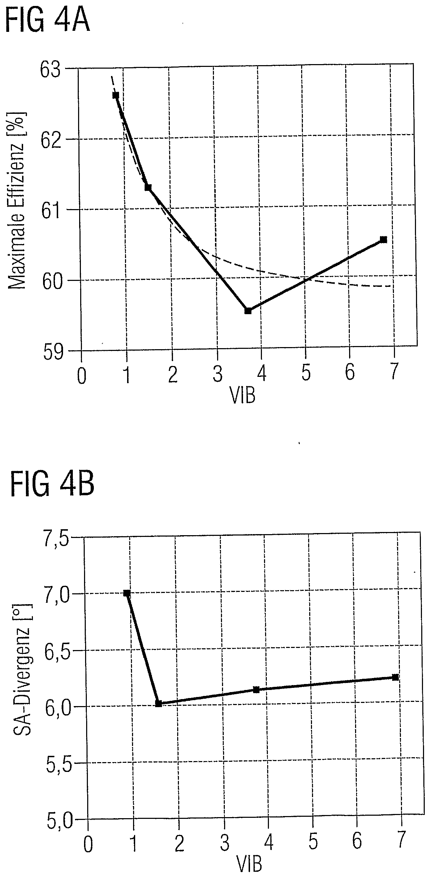

Die Figur 4A zeigt eine schematische Darstellung der Effizienz eines kantenemittierenden Halbleiterlaserchips gegen das Verhältnis vom größten Abstand V zwischen zumindest einer der Strombarrieren und dem Kontaktstreifen zur Breite B des Kontaktstreifens. Die gestrichelte Linie in Figur 4A stellt eine Trendlinie dar, die Abweichungen sind durch schwankende Messwerte zu erklären.

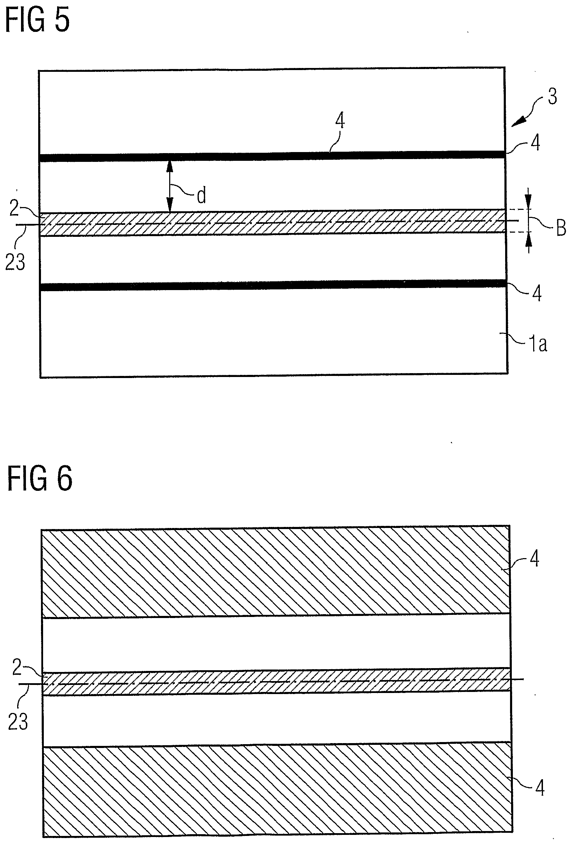

Die Figur 4B zeigt eine schematische Darstellung der horizontalen Strahldivergenz bei einem Leistungseinschluss von 95 %, aufgetragen gegen V/B für einen kantenemittierenden Halbleiterlaserchip, der abgesehen von dem Verhältnis V/B den gleichen Aufbau aufweist. Dabei wird ein Kontaktstreifen mit einer Breite von 70 µm angenommen. Die Anordnung der Strombarrieren 4 zum Kontaktstreifen 2 entspricht dabei dem in Verbindung mit der Figur 5 beschriebenen Ausführungsbeispiel.

Wie der Figur 4A zu entnehmen ist, liegt das Optimum der Effizienz im Bereich geringer Abstände zwischen Strombarrieren und Kontaktstreifen mit V/B < 1. Andererseits tritt in diesem Bereich von V/B eine erhöhte horizontale Strahldivergenz (slow axis, SA-Strahldivergenz) auf (siehe die Figur 4B). Ab einem Verhältnis V/B ≈ 1,5 ist ein Sättigungswert der Divergenz von etwa 6° erreicht. Das heißt, bei gezielter Vergrößerung des Verhältnisses V/B > 1,0, vorzugsweise > 1,2 erhält man eine wesentlich geringere horizontale Divergenz bei moderater Verschlechterung der Effizienz des kantenemittierenden Halbleiterlaserchips 1.

Dabei liegt der Erfindung unter anderem die Erkenntnis zugrunde, dass die inhomogene Temperaturverteilung im kantenemittierenden Halbleiterlaserchip durch Heizleistung in den Randbereichen des Halbleiterlaserchips 1, außerhalb des Emitters teilweise kompensiert werden kann. Dadurch wird der Effekt der thermischen Linse abgeschwächt, was zu einer verringerten Divergenz der Laserstrahlung in horizontaler Richtung führt. Durch einen vergrößerten Abstand der Strombarrieren 4 zum Kontaktstreifen 2 steigt wegen der lateralen Stromaufweitung die Stromdichte und damit die Heizleistung im Außenbereich des Emitters, das heißt in Nähe der Strombarrieren, an. Dabei wird die Ladungsträgerinjektion derart begrenzt, dass im Außenbereich keine Ladungsträgerinversion erzeugt wird. Das heißt, die Stromdichte in Nähe der Strombarrieren reicht nicht aus, um zu einer Lasertätigkeit zu führen. In der Nähe der Strombarrieren wird lediglich Verlustwärme erzeugt, was die Effizienz des Bauelements senkt (vergleiche Figur 4A). Das Verhältnis der im Außenbereich erzeugten elektrischen Verlustleistung zu der im effektiv emittierenden Bereich erzeugten elektrischen Verlustleistung steigt wegen der sich vergrößernden Strom tragenden Fläche mit wachsendem Abstand V der Strombarrieren 4 vom Kontaktstreifen 2 an.

Die Figur 5 zeigt ein Ausführungsbeispiel eines hier beschriebenen kantenemittierenden Halbleiterlaserchips in einer Draufsicht auf die Oberseite 1a des kantenemittierenden Halbleiterlaserchips 1. In diesem Ausführungsbeispiel sind Strombarrieren 4 achsensymmetrisch und parallel zur Längsmittelachse 23 eines Kontaktstreifens 2, der beispielsweise mittels einer Metallisierung auf die Kontaktschicht 15 des Halbleiterlaserchips 1 gebildet ist, angeordnet.

Die Strombarrieren sollen eine Stromaufweitung in den Halbleiterschichten zwischen der aktiven Zone 14 und dem Kontaktstreifen 2 verhindern. Dies kann auf unterschiedliche Arten realisiert werden.

Zum einen ist es möglich, dass von der Oberseite 1a, das heißt von der Kontaktschicht 15 weg, Gräben bis mindestens unterhalb der aktiven Schicht 14 geätzt werden. Diese Gräben sind dann vorzugsweise zwischen den einzelnen Emittern des kantenemittierenden Halbleiterlaserchips angeordnet. Diese Gräben unterdrücken Ring- und Quermoden. Die Gräben müssen nicht zwingend achsensymmetrisch zum Kontaktstreifen 2 angeordnet sein. Die Ätzflanken der Gräben können mit Material bedeckt sein, das zur Absorption der in der aktiven Zone erzeugten elektromagnetischen Strahlung geeignet ist. Beispielsweise in der Druckschrift US 6,947,464 ist ein kantenemittierender Halbleiterlaserchip mit solchen Gräben beschrieben.

Eine weitere Möglichkeit zur Erzeugung von Strombarrieren 4 besteht darin, Fremdatome in den Halbleiter zu implantieren und auf diese Weise die elektrische Leitfähigkeit der Schichten zwischen der aktiven Zone und dem Kontaktstreifen gezielt zu zerstören. Dabei reicht es aus, wenn die Implantation bis zur aktiven Zone 14 erfolgt.

Beim Ausführungsbeispiel, das in Verbindung mit Figur 5 beschrieben ist, befinden sich die Laserfacetten rechts und links in der Figur. Die Auskoppelfacette 3 befindet sich auf der rechten Seite.

Die Figur 6 zeigt einen hier beschriebenen Halbleiterlaserchip gemäß einem Ausführungsbeispiel in einer schematischen Draufsicht. In diesem Ausführungsbeispiel sind großflächige Strombarrieren 4 achsensymmetrisch zur Längsmittelachse 23 des Kontaktstreifens 2 angebracht.

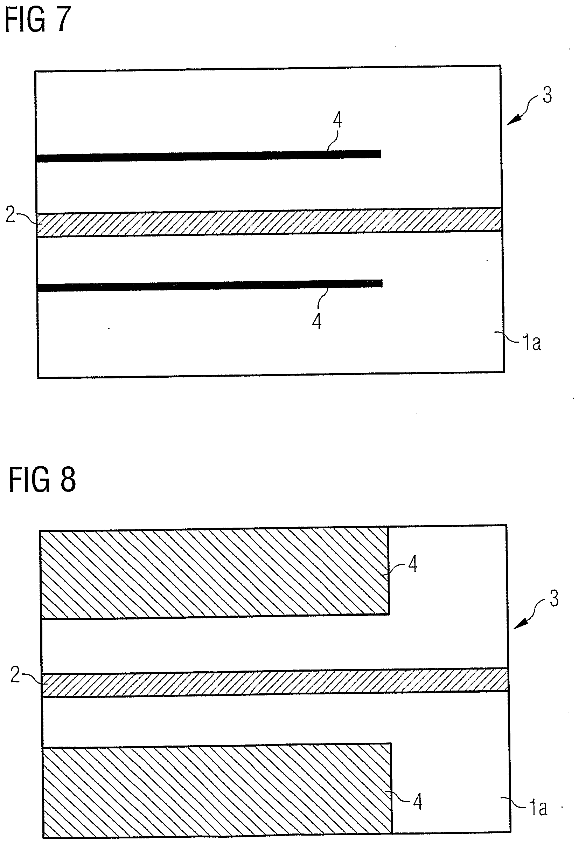

Die Figur 7 zeigt in schematischer Draufsicht ein Ausführungsbeispiel eines hier beschriebenen kantenemittierenden Halbleiterlaserchips mit symmetrisch angebrachten streifenförmigen Strombarrieren 4. Die Strombarrieren 4 reichen hier nicht bis zur Auskoppelfacette 3. Der Abstand zur Auskoppelfacette 3 kann dabei bis hin zu einigen Millimetern betragen. Dadurch ergibt sich an der Auskoppelfacette 3 eine größere laterale Stromaufweitung und eine weitere Homogenisierung des Temperaturprofils im Halbleiterlaserchip. Auf diese Weise kann der in Verbindung mit Figur 3A beschriebene Effekt der thermischen Linse weiter reduziert werden.

Die Figur 8 zeigt ein weiteres Ausführungsbeispiel eines hier beschriebenen kantenemittierenden Halbleiterlaserchips in einer schematischen Draufsicht. Im Unterschied zum Ausführungsbeispiel der Figur 7 sind die Strombarrieren hier großflächig ausgebildet.

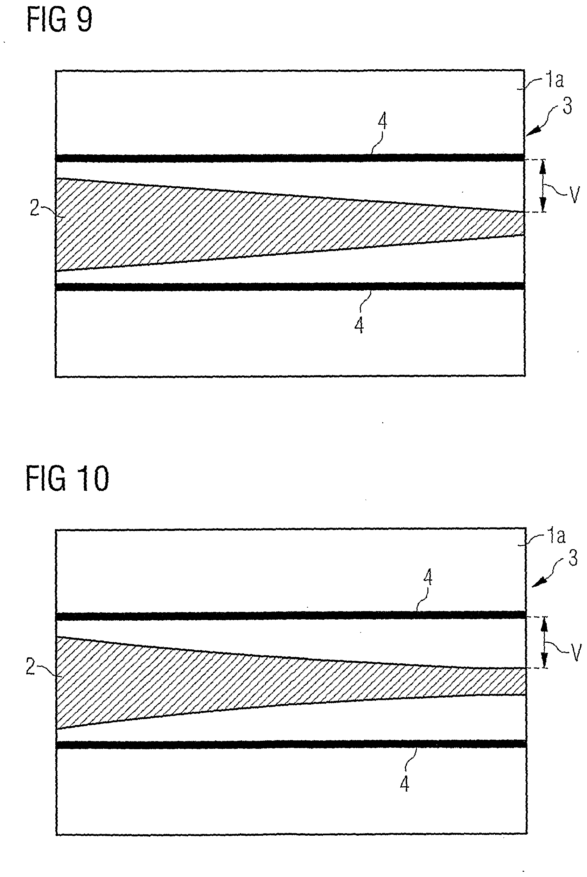

Die Figur 9 zeigt ein Ausführungsbeispiel eines erfindungsgemäßen kantenemittierenden Halbleiterlaserchips, bei dem sich der Abstand der Strombarriere 4 vom Kontaktstreifen 2 durch eine Verkleinerung der Kontaktstreifenbreite B in Richtung der Auskoppelseite 3 hin vergrößert. Auf diese Weise ist ebenfalls eine Vergrößerung der lateralen Stromaufweitung erreicht. In Verbindung mit der Figur 10 ist ein Ausführungsbeispiel eines erfindungsgemäßen kantenemittierenden Halbleiterlaserchips gezeigt, bei dem im Unterschied zum Ausführungsbeispiel der Figur 9 die Kontaktstreifenbreite nicht linear zur Auskoppelfacette 3 hin verringert wird. Je nach Wahl der Form des Kontaktstreifens 2 kann auf diese Weise ein gewünschtes Temperaturprofil im Halbleiterlaserchip eingestellt werden.

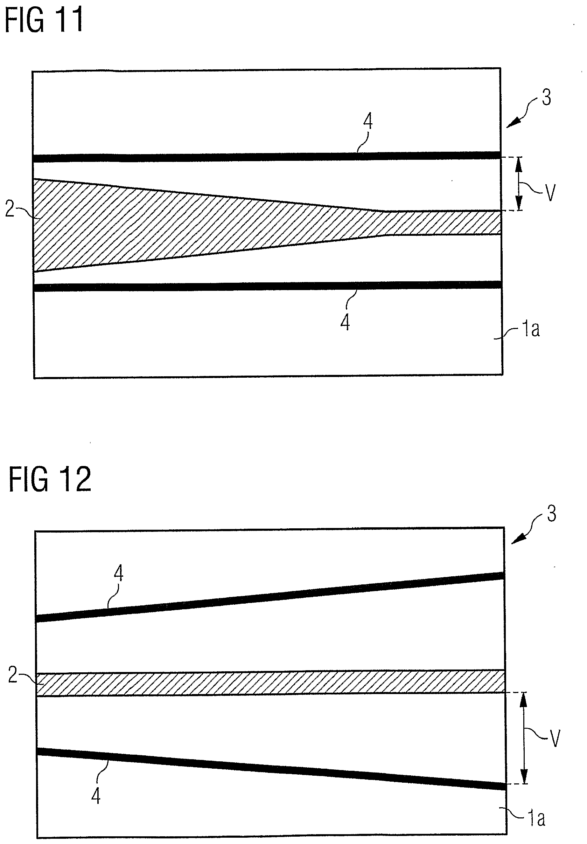

In Verbindung mit Figur 11 ist ein Ausführungsbeispiel eines erfindungsgemäßen kantenemittierenden Halbleiterlaserchips beschrieben, bei dem der Abstand der Strombarriere 4 vom Kontaktstreifen 2 durch Variation der Kontaktstreifenbreite in Bereichen des Halbleiterlaserchips vergrößert wird. Der größte Abstand V befindet sich wiederum in der Nähe der Auskoppelfacette 3.

Die Figur 12 zeigt ein Ausführungsbeispiel eines erfindungsgemäßen kantenemittierenden Halbleiterlaserchips, bei dem der Abstand der Strombarriere 4 vom Kontaktstreifen 2 zur Auskoppelfacette 3 hin linear vergrößert wird. Dabei weist der Kontaktstreifen 2 eine konstante Breite auf, wohingegen der Abstand der Strombarrieren 4 vom Kontaktstreifen 2 entlang einer geraden Linie vergrößert wird. Dies führt zu einer vergrößerten lateralen Stromaufweitung und damit zu einer Homogenisierung des Temperaturprofils in der Nähe der Auskoppelfacette 3.

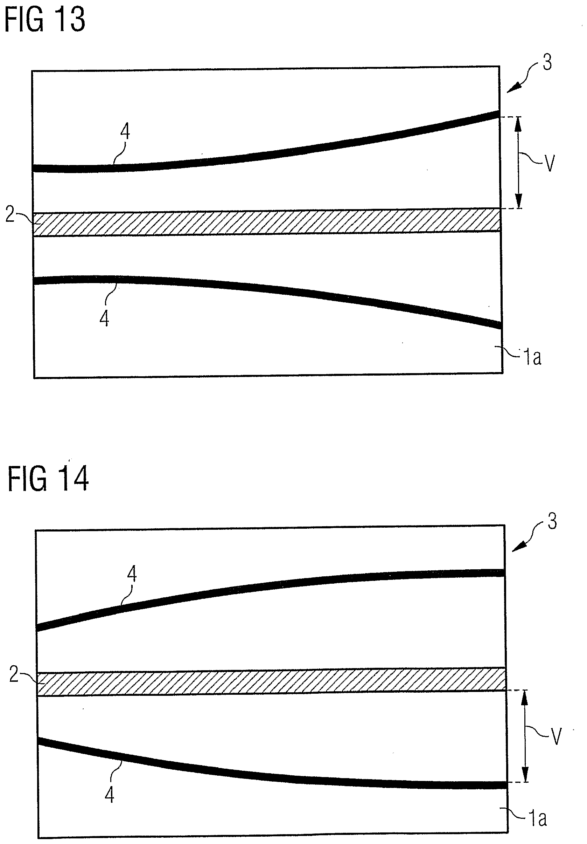

Die Figur 13 zeigt ein Ausführungsbeispiel eines erfindungsgemäßen kantenemittierenden Halbleiterlaserchips in einer schematischen Draufsicht, bei dem im Unterschied zum Ausführungsbeispiel der Figur 12 eine nicht-lineare Vergrößerung des Abstands zwischen den Strombarrieren 4 und dem Kontaktstreifen 2 stattfindet.

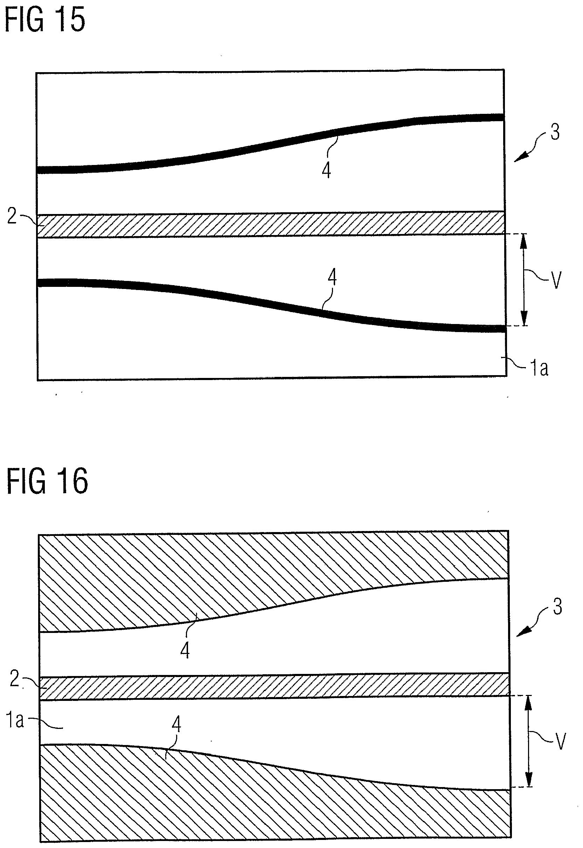

Die Figur 14 zeigt in einer schematischen Draufsicht ein Ausführungsbeispiel eines erfindungsgemäßen kantenemittierenden Halbleiterlaserchips, bei dem der Verlauf der Strombarrieren der Form der thermischen Linse, wie sie beispielsweise aus der Figur 3A ersichtlich ist, nachgeführt ist. Auch in den in Verbindung mit den Figuren 15 und 16 erfindungsgemäßen Ausführungsbeispielen des kantenemittierenden Halbleiterlaserchips ist eine Anpassung des Abstands der Strombarrieren 4 vom Kontaktstreifen 2 an die thermische Linse durch nicht lineare Vergrößerung des Abstands gezeigt. Dabei zeigt die Figur 16 eine großflächige Strombarriere.

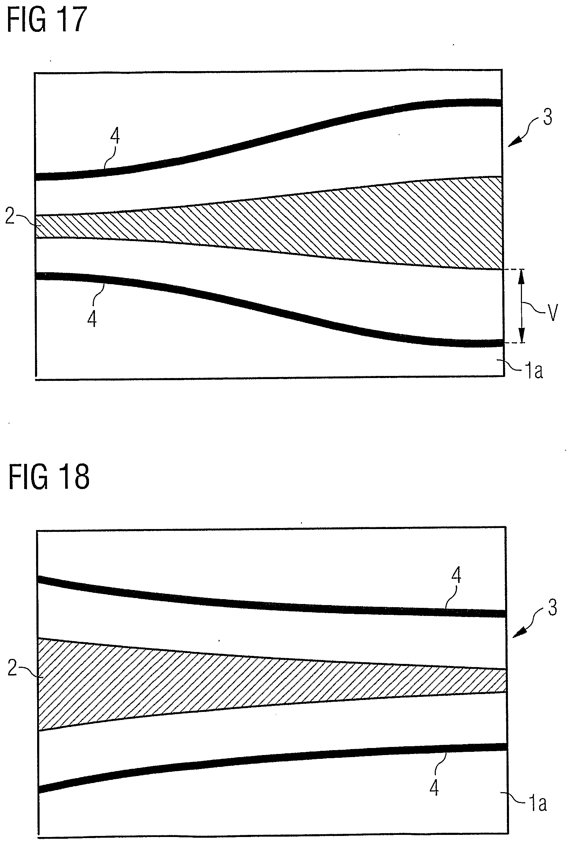

In den erfindungsgemäßen Ausführungsbeispielen des kantenemittierenden Halbleiterlaserchips, die in Verbindung mit den Figuren 17 und 18 beschrieben sind, wird das Verhältnis V/B in Richtung der Auskoppelfacette 3 bei gleichzeitiger Variation der Kontaktstreifenbreite B und des Abstands der Strombarrieren 4 vom Kontaktstreifen 2 vergrößert.

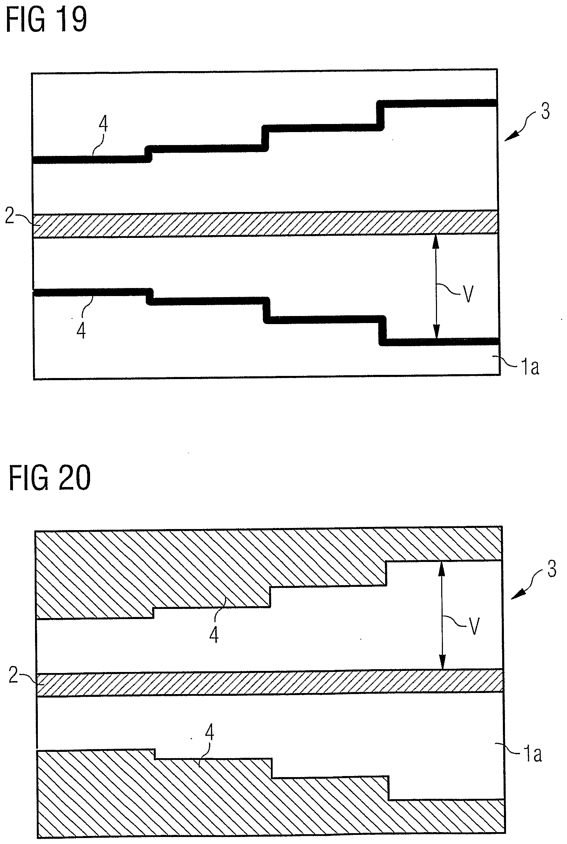

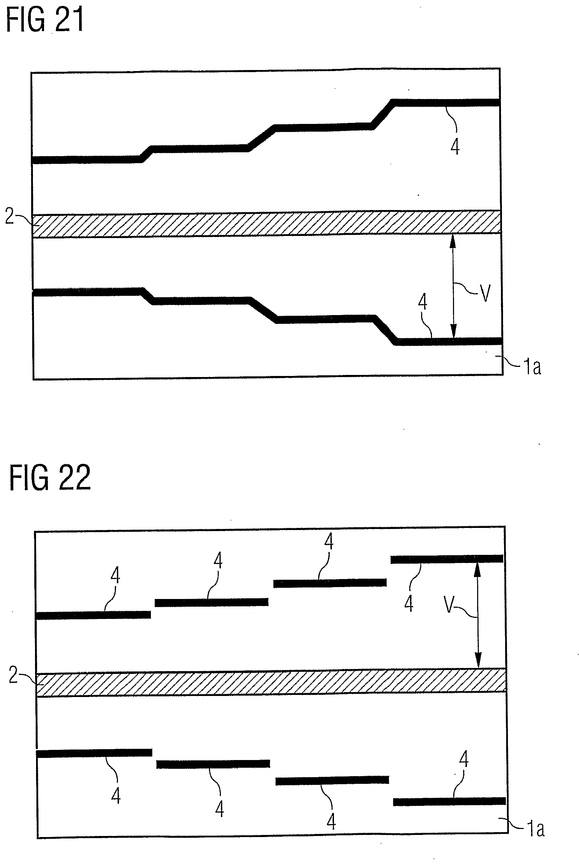

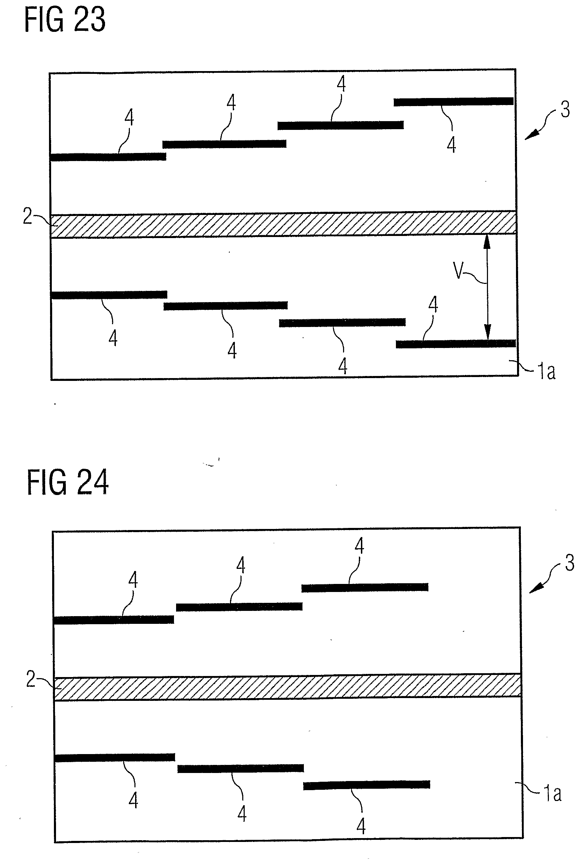

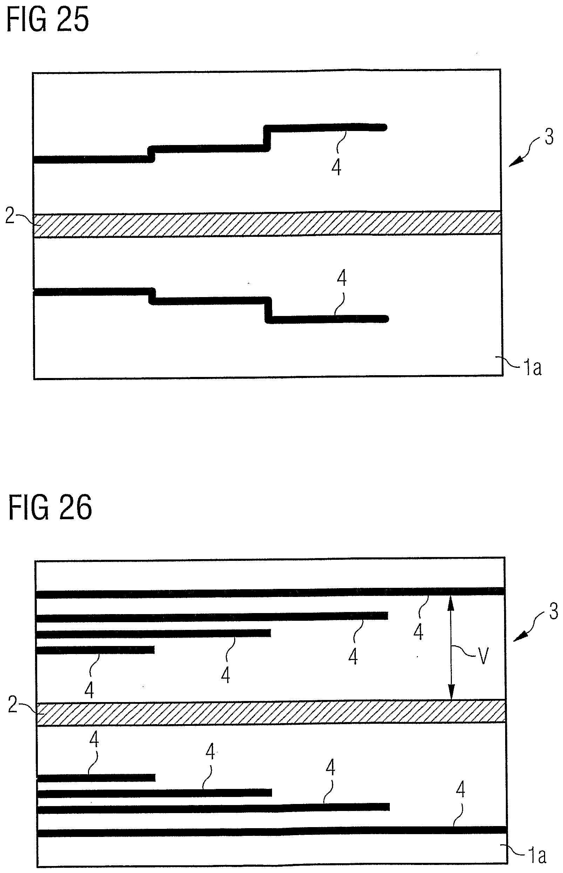

In den in Verbindung mit den Figuren 19 bis 26 beschriebenen Ausführungsbeispielen eines erfindungsgemäßen kantenemittierenden Halbleiterlaserchips wird der Abstand zwischen Kontaktstreifen 2 und Strombarrieren 4 diskontinuierlich geändert. Dabei ist es, wie in den Figuren 22 bis 24 gezeigt, auch möglich, dass die Strombarrieren 4 aus mehreren Strombarrieren zusammengesetzt sind, welche sich längs des Kontaktstreifens 2 erstrecken. Dabei sind Ausführungsformen mit und ohne Überlapp der einzelnen Strombarrieren möglich. Stormbarrieren mit diskontinuierlichem Verlauf bieten den Vorteil, dass sie besonders einfach herstellbar sind. So können beispielsweise bei kristallrichtungsabhängigen Ätzraten bei der Ätzung der Stormbarrieren Probleme vermieden werden. Darüber hinaus ist die Überprüfung der Einhaltung von Toleranzen gegenüber Strukturen, wie sie zum Beispiel in Verbindung mit der Figur 10 beschrieben sind, erleichtert.

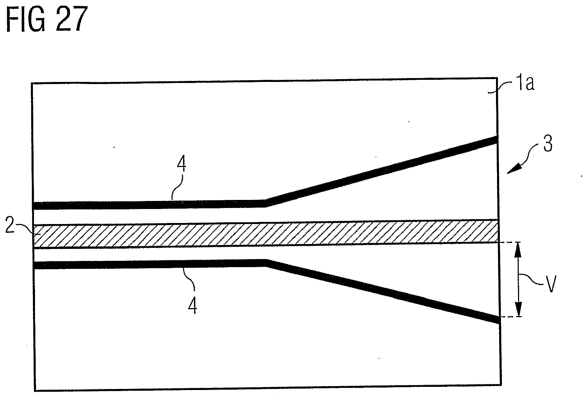

In Verbindung mit Figur 27 ist ein erfindungsgemäßes Ausführungsbeispiel des kantenemittierenden Halbleiterlaserchips beschrieben, bei dem der Abstand zwischen Strombarriere 4 und Kontaktstreifen 2 nur in Nähe der Auskoppelfacette 3 vergrößert ist. In Nähe der Auskoppelfacette 3 kann das Verhältnis V/B beispielsweise ≥ 1,2 sein, wohingegen das Verhältnis V/B im übrigen Bereich des Halbleiterlaserchips < 1 ist. Auf diese Weise wird über einen großen Teil des Resonators das für die Effizienz des Halbleiterlaserchips ideale Verhältnis V/B < 1 genutzt (vergleiche dazu auch Figur 4A), wohingegen lediglich in der Nähe der Auskoppelfacette 3 ein größeres Verhältnis V/B gewählt wird, durch das sich der Effekt der thermischen Linse wie oben beschrieben verringern lässt.

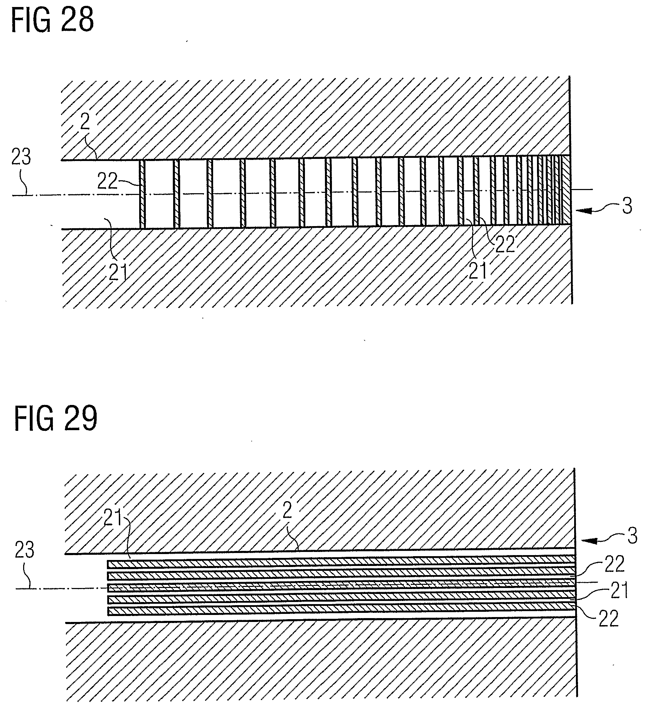

Eine weitere Möglichkeit, das Temperaturprofil an der Auskoppelfacette 3 des Halbleiterlaserchips 1 zu homogenisieren und damit den negativen Effekt der thermischen Linse abzuschwächen um eine verringerte Strahldivergenz zu erreichen, besteht darin, den Kontaktstreifen 2 zu strukturieren. Die Figuren 28 bis 31 zeigen Möglichkeiten zur Strukturierung des Kontaktstreifens 2, welche mit jedem der in den Figuren 5 bis 27 gezeigten Ausführungsbeispiele kombiniert werden können. Das heißt, die Kontaktstreifen in den Figuren 5 bis 27 können durch einen Kontaktstreifen, wie er in den Figuren 28 bis 31 gezeigt ist, ausgetauscht werden. Durch diese Maßnahme entstehen Halbleiterlaserchips mit besonders stark reduzierter Strahldivergenz in horizontaler Richtung.

Die Figur 28 zeigt einen Kontaktstreifen 2 eines hier beschriebenen kantenemittierenden Halbleiterlaserchips 1 in einer schematischen Draufsicht. Der Kontaktstreifen 2 kann sich an der Oberseite 1a und/oder an der Unterseite 1b des Halbleiterlaserchips 1 befinden. Der Kontaktstreifen 2 ist derart strukturiert, dass eine Ladungsträgerinjektion in die aktive Zone 14 zu einer Seite des Halbleiterlaserchips 1 hin abnimmt, an der sich die Auskoppelfacette 3 des Halbleiterlaserchips 1 befindet.

Eine strukturierte Stromeinprägung auf der Ober- und/oder Unterseite des Halbleiterlaserchips 1 führt über die damit ebenfalls strukturierte Verteilung der ohmschen Verlustleistungsdichte im Halbleiterlaserchip 1 zu einer gezielten Beeinflussung der thermischen Linse im Resonator des Halbleiterlaserchips 1. Der Resonator ist dabei durch die Auskoppelfacette 3 und die der Auskoppelfacette 3 gegenüberliegende Seite des Halbleiterlaserchips 1 gebildet. Als besonders vorteilhaft erweist sich eine Strukturierung des Kontaktstreifens 2 in longitudinaler Richtung, das heißt in Richtung längs der Längsmittelachse 23 des Kontaktstreifens 2, und/oder in lateraler Richtung, das heißt in Richtung quer beziehungsweise senkrecht zur Längsmittelachse 23 des Kontaktstreifens 2. Überraschend hat sich nämlich herausgestellt, dass in diesen Fällen die Temperaturverteilung homogenisiert wird und dies der Verzerrung der Phasenfronten aufgrund der thermischen Linse entgegenwirkt. Damit verringert sich die Divergenz des im Emitter erzeugten Laserstrahls in horizontaler Richtung. Der Kontaktstreifen 2 ist in Bereiche niedriger Ladungsträgerinjektion 22 sowie hoher Ladungsträgerinjektion 21 aufgeteilt. Durch die Bereiche niedriger Ladungsträgerinjektion 22 wird kaum oder gar kein Strom in die aktive Zone 14 eingeprägt. Dahingegen wird in den Bereichen hoher Ladungsträgerinjektion 21 Strom ähnlich in die aktive Zone 14 eingeprägt wie im unstrukturierten Fall.

Die Strukturierung der Stromeinprägung kann dabei wie folgt geschehen:
Eine Möglichkeit der Strukturierung des Kontaktstreifens und damit der Ladungsträgerinjektion besteht darin, dass eine entsprechend strukturierte Passivierungsschicht auf den Halbleiterlaserchip 1 aufgebracht ist, derart, dass die Passivierungsschicht nur in den Bereichen hoher Ladungsträgerinjektion 21 entfernt ist, sodass dort ein Kontakt zwischen dem Material des Kontaktstreifens 2 - üblicherweise einem Metall - und dem Halbleitermaterial des Halbleiterlaserchips 1 besteht.

Ferner ist es möglich, dass die Strukturierung mittels strukturierter Entfernung der obersten Halbleiterschicht des Halbleiterlaserchips 1 vor Aufbringen der metallischen Schicht des Kontaktstreifens 2 und dadurch Strukturierung des Kontaktwiderstands zwischen dem Halbleitermaterial und dem Metall des Kontaktstreifens 2 erzeugt ist.

Ferner kann eine strukturierte Implantation oder Einlegierung von Fremdatomen zur Veränderung des Kontaktwiderstands zwischen dem Kontaktstreifen 2 und dem Halbleitermaterial des Halbleiterlaserchips 1 erfolgen. Alternativ zur Veränderung des Kontaktwiderstands oder zusätzlich zur Veränderung des Kontaktwiderstands kann durch Implantation oder Einlegierung auch die Leitfähigkeit des Halbleitermaterials unterhalb des Kontaktstreifens 2 verändert werden. Auch auf diese Weise ist der Kontaktstreifen 2 in Bereiche hoher und niedriger Ladungsträgerinjektion strukturiert.

Eine weitere Möglichkeit zur Strukturierung des Kontaktstreifens und damit der Ladungsträgerinjektion besteht darin, vor der Abscheidung des Kontaktstreifens 2 über die beispielsweise p-dotierte Kontaktschicht 15 eine n-dotierte Halbleiterschicht aufzubringen, die dann strukturiert wieder entfernt wird. Auf diese Weise bilden sich an den Stellen, wo die n-dotierte Schicht noch vorhanden ist, im Betrieb gesperrte pn-Dioden, welche den Stromfluss wirksam behindern. Nur dort, wo die n-dotierte Schicht entfernt ist, kann dann Strom injiziert werden. Diese Bereiche bilden die Bereiche hoher Ladungsträgerinjektion 21.

In gleicher Weise kann eine p-dotierte Halbleiterschicht über einer n-dotierten Kontaktschicht 15 aufgebracht werden, wodurch nach strukturiertem Entfernen der p-dotierten Schicht der gleiche Effekt eintritt.

Eine weitere Möglichkeit zur Strukturierung der Ladungsträgerinjektion besteht darin, dass durch Quantenwell-Intermixing die Ladungsträgerrekombination in der aktiven Zone 14 und damit die Erzeugung von Verlustwärme in der aktiven Zone 14 an diesen Stellen unterbunden wird. Durch strukturierte Durchführung des Quantenwell-Intermixing können auf diese Weise Bereiche hoher und niedriger Ladungsträgerinjektion in die aktive Zone 14 erzeugt werden.

Eine weitere Möglichkeit zur Strukturierung des Kontaktstreifens und damit der Ladungsträgerinjektion besteht darin, lokal den Kontaktstreifen 2 aus unterschiedlichen Metallen oder anderen Materialien zu bilden, welche unterschiedliche elektrische Übergangswiderstände an der Grenzfläche zwischen diesen Materialien und der Kontaktschicht 15 des Halbleiterlaserchips aufweisen. Auch dies führt zu einer strukturierten Ladungsträgerinjektion und einer Aufteilung der Kontaktschicht 2 in Bereiche hoher Ladungsträgerinjektion 21 und Bereiche niedriger Ladungsträgerinjektion 22. Diese Methode vermeidet gleichzeitig eine Variation der Wärmeleitfähigkeit des Kontaktstreifens 2 und folglich eine Variation des Wärmeabtransports aus dem Halbleiterlaserchip 1. Eine räumliche Modulation der thermischen Linsen, welche die Homogenität des erzeugten Laserlichts beeinträchtigen könnte, wird dadurch vermieden. Beispielsweise ist die Kontaktschicht 15 dabei aus p-dotiertem GaAs gebildet. In Bereichen hoher Storminjektion ist der Kontaktstreifen dann aus Cr/Pt/Au gebildet, wobei Cr das für den niedrigen Kontaktwiderstand entscheidende Metall ist. In Bereichen niedriger Storminjektion findet zum Beispiel Aluminium Verwendung.

Im Ausführungsbeispiel der Figur 28 variiert die Ladungsträgerinjektion nahe der Auskoppelfacette 3 in longitudinaler Richtung, parallel zur Längsachse 23 des Kontaktstreifens 2. Auf diese Weise wird der Temperaturanstieg an der Auskoppelfacette 3 verringert und die Temperaturverteilung im Halbleiterlaserchip 1 ausgeglichen.

Die Figur 29 zeigt den Kontaktstreifen 2 eines hier beschriebenen kantenemittierenden Halbleiterlasers. In diesem Ausführungsbeispiel variiert die Ladungsträgerinjektion in lateraler Richtung, das heißt in Richtung quer zur Längsachse 23. Die Strukturierung erfolgt dabei vorzugsweise nur in Nähe der Auskoppelfacette 3. Über die restliche Länge des Kontaktstreifens 2 erfolgt keine Strukturierung. Durch die Strukturierung wird die Stromdichte des in die aktive Zone eingeprägten Stroms in der Mitte des Resonators des Halbleiterlaserchips an der Auskoppelfacette 3 lokal minimiert. Die Strukturierung besteht aus Bereichen hoher Ladungsträgerinjektion 21 und streifenartigen Bereichen niedriger Ladungsträgerinjektion 22, wobei in der Mitte des Kontaktstreifens 2 besonders wenig Strom injiziert wird und der Flächenanteil der Bereiche hoher Ladungsträgerinjektion 21 dort besonders klein ist. Das heißt, der relative Anteil an der Gesamtfläche beziehungsweise das Verhältnis zu den benachbarten Bereichen niedriger Ladungsträgerinjektion ist dort besonders klein.

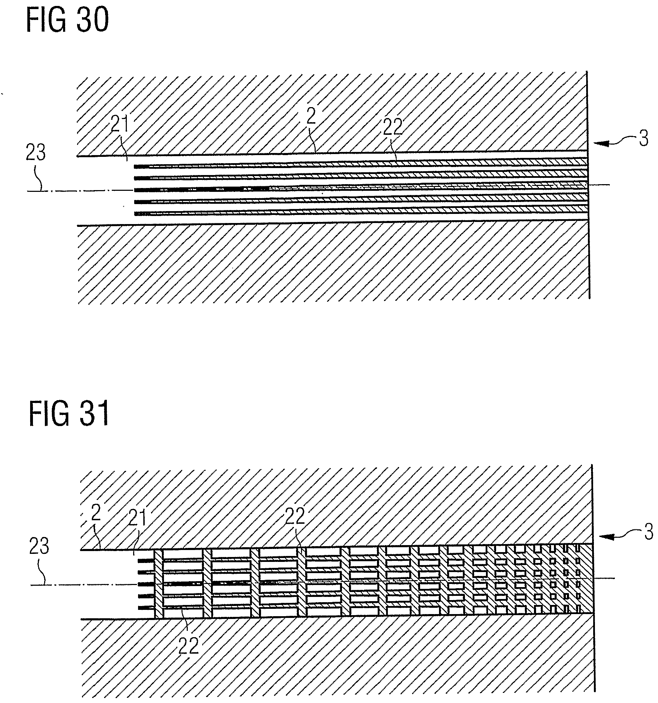

Die Figur 30 zeigt den Kontaktstreifen 2 eines hier beschriebenen kantenemittierenden Halbleiterlaserchips 1. In diesem Ausführungsbeispiel ist die Stromdichte in der aktiven Zone 14 durch Strukturierung des Kontaktstreifens 2 in longitudinaler und lateraler Richtung nahe der Auskoppelfacette 3 mit einem weicheren Übergang vom unstrukturierten zum strukturierten Bereiche gegeben. In diesem Fall verjüngen sich die Bereiche hoher Ladungsträgerinjektion 21 in Richtung der Auskoppelfacette 3, während die Bereiche niedriger Ladungsträgerinjektion 22 in dieser Richtung breiter werden.

Die Figur 31 zeigt den Kontaktstreifen 2 eines hier beschriebenen kantenemittierenden Halbleiterlaserchips 1. In diesem Ausführungsbeispiel sind die Strukturierungsmaßnahmen des Kontaktstreifens 2 aus den Ausführungsbeispielen zur Figur 28 und zur Figur 30 kombiniert. Auf diese Weise wird eine noch stärkere Änderung der in die aktive Zone 14 injizierten Stromdichte erreicht.

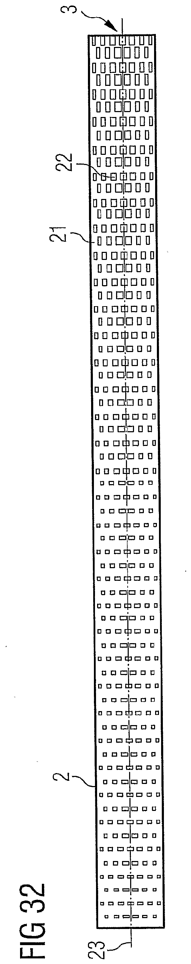

In Verbindung mit der Figur 32 ist eine Halbtonstrukturierung des Kontaktstreifens 2 beschrieben. Die Rechtecke in der Figur 32 schließen Bereiche geringer Ladungsträgerinjektion 22 ein, im Mittel nimmt also die injizierte Stromdichte zur Auskoppelfacette 3 hin sowie zur Mittelachse 23 hin ab. Die Strukturierung ist dabei durch eine der oben beschriebenen Strukturierungsmaßnahmen gegeben. Das heißt, zum Beispiel kann in den Bereichen geringer Injektion 22 eine Passivierungsschicht vorhanden sein.

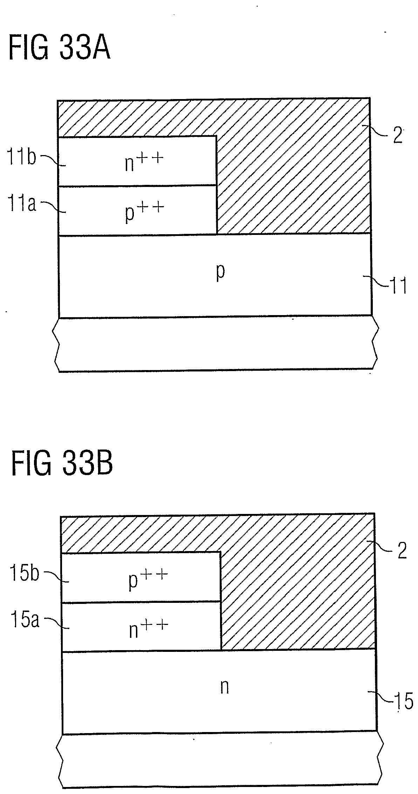

Die Figuren 33A und 33B zeigen eine weitere Möglichkeit zur Strukturierung der Ladungsträgerinjektion anhand einer schematischen Schnittdarstellung durch einen Teil des Halbleiterlaserchips 1.

Die Strukturierung des Kontaktstreifens 2 erfolgt dabei über einen Tunnelkontakt. Ein sehr hoch dotierter pn-Übergang insbesondere in Sperrrichtung bildet einen Tunnelkontakt. Dieser Tunnelkontakt kann bei entsprechender Gestaltung ohmsch sein, das heißt er weist dann eine lineare Strom-Spannungskennlinie auf.

In Figur 33A ist dargestellt, dass eine hoch p-dotierte Tunnelschicht 11a auf die p-Kontaktschicht 11 des Halbleiterlaserchips 1 aufgebracht ist. Der hoch p-dotierten Tunnelkontaktschicht 11a folgt eine hoch n-dotierte Tunnelkontaktschicht 11b nach. Die Tunnelkontaktschichten werden vorzugsweise zumindest dort, wo sich später ein Kontaktstreifen 2 befinden soll, ganzflächig auf die p-Kontaktschicht 11 aufgebracht und nach ihrer Epitaxie stellenweise entfernt.

Aufgrund des unterschiedlichen elektrischen Kontaktwiderstands zwischen dem Metall des Kontaktstreifens 2 und n- beziehungsweise p-dotierten Halbleitern ergibt sich in den Bereichen mit Tunnelschichten und den Bereichen ohne Tunnelschichten jeweils eine unterschiedliche Ladungsträgerinjektion. Auf diese Weise sind also Bereiche niedriger Ladungsträgerinjektion 22 sowie hoher Ladungsträgerinjektion 21 erzeugt.

Bei schlechtem Kontakt zwischen Metall und p-dotiertem Halbleiter und gutem Kontakt zwischen Metall und n-dotiertem Halbleiter ergibt sich im Bereich der Tunnelschichten eine hohe Stromdichte in der aktiven Zone sowie im Bereich ohne Tunnelschichten eine niedrige Stromdichte. Andererseits ergibt sich bei schlechtem Kontakt zwischen Metall und n-dotiertem Bereich und gutem Kontakt zwischen Metall zu p-dotiertem Bereich eine niedrige Stromdichte, das heißt ein Bereich geringer Ladungsträgerinjektion 22, im Bereich der Tunnelschichten und eine hohe Stromdichte, dort wo die Tunnelschichten entfernt worden sind.

Die gleiche Möglichkeit zur Strukturierung besteht auch auf der n-Seite des Halbleiterlaserchips 1. Dies ist in Verbindung mit der Figur 33B beschrieben. Hier ist auf die n-Kontaktschicht 15 eine hoch n-dotierte Tunnelschicht 15a sowie auf diese eine hoch p-dotierte Tunnelschicht 15b aufgebracht. Bei schlechtem Kontakt von Metall zu p-dotiertem Bereich und gutem Kontakt von Metall zu n-dotiertem Bereich ergibt sich, dort wo die Tunnelschichten belassen wurden, eine niedrige Stromdichte in der aktiven Zone, wohingegen sich dort, wo die Tunnelschichten entfernt wurden und ein Kontakt zwischen dem Metall und der n-dotierten Kontaktschicht 15 besteht, eine hohe Stromdichte. Ferner ergibt sich bei schlechtem Kontakt von Metall zum n-dotierten Bereich und gutem Kontakt von Metall zum p-dotierten Bereich eine hohe Stromdichte im Bereich der Tunnelschichten und eine niedrige Stromdichte dort, wo ein Metall zu n-Kontakt hergestellt wurde.

Die Erfindung ist nicht durch die Beschreibung anhand der Ausführungsbeispiele beschränkt.

## Patentansprüche

1. Kantenemittierender Halbleiterlaserchip (1) mit
- einer aktiven Zone (14), in der im Betrieb des Halbleiterlaserchips (1) elektromagnetische Strahlung erzeugt wird,
- zumindest einem Kontaktstreifen (2), wobei der Kontaktstreifen eine Breite B aufweist,
- zumindest zwei Strombarrieren (4), die auf unterschiedlichen Seiten des Kontaktstreifens (2) angeordnet sind und sich längs des Kontaktstreifens (2) erstrecken, wobei der größte Abstand V zwischen jeder der beiden Strombarrieren (4) und dem Kontaktstreifen (2) derart gewählt ist, dass das Verhältnis von größtem Abstand V zur Breite B V/B > 1,0 ist, wobei
- sich die Strombarrieren (4) bis zur aktiven Zone (14) erstrecken, wobei die Strombarrieren (4) eine laterale Stromaufweitung verhindern, sodass mittels des zumindest einen Kontaktstreifens (2) eingeprägter elektrischer Strom sich nicht derart aufweitet, dass die gesamte aktive Zone (14) bestromt wird, sondern nur ein bestimmter vorgebbarer Ausschnitt der aktiven Zone mit dem Strom beaufschlagt wird, und
- der Abstand zumindest einer Strombarriere (4) vom Kontaktstreifen (2) mit abnehmendem Abstand zu der Seite, an der sich eine Auskoppelfacette (3) des Halbleiterlaserchips (1) befindet, zunimmt.

2. Kantenemittierender Halbleiterlaserchip nach dem vorherigen Anspruch,
bei dem sich der größte Abstand V in der Nähe der Seite des Halbleiterlaserchips (1) befindet, an der sich eine Auskoppelfacette (3) des Halbleiterlaserchips (1) befindet.

3. Kantenemittierender Halbleiterlaserchip nach zumindest einem der vorherigen Ansprüche,
bei dem die Strombarrieren (4) achsensymmetrisch zur Längsmittelachse (23) des Kontaktstreifens (2) angeordnet sind.

4. Kantenemittierender Halbleiterlaserchip nach zumindest einem der vorherigen Ansprüche,
bei dem der Verlauf zumindest einer der Strombarrieren (4) zumindest stellenweise in einer Ebene parallel zur Erstreckungsebene des Kontaktstreifens (2) stufenartig ist.

5. Kantenemittierender Halbleiterlaserchip nach zumindest einem der vorherigen Ansprüche mit
zumindest zwei Kontaktstreifen (2).

6. Kantenemittierender Halbleiterlaserchip nach zumindest einem der vorherigen Ansprüche mit zumindest einem strukturierten Kontaktstreifen (2), der derart strukturiert ist, dass eine Ladungsträgerinjektion in die aktive Zone (14) zu einer Seite des Halbleiterlaserchips (1) hin abnimmt, an der sich die Auskoppelfacette (3) des Halbleiterlaserchips (1) befindet, wobei der Kontaktstreifen (2) in Bereiche hoher (21) und Bereiche niedriger (22) Ladungsträgerinjektion strukturiert ist.

7. Kantenemittierender Halbleiterlaserchip nach dem vorherigen Anspruch,
bei dem der Flächenanteil der Bereiche hoher (21) Ladungsträgerinjektion mit kleiner werdendem Abstand zu der Seite des Halbleiterlaserchips hin abnimmt, an der sich eine Auskoppelfacette (3) des Halbleiterlaserchips (1) befindet.

8. Kantenemittierender Halbleiterlaserchip nach zumindest einem der vorherigen Ansprüche,
bei dem der Kontaktstreifen (2) in einer Richtung quer zur Längsmittelachse (23) des Kontaktstreifens (2) in Bereiche hoher (21) und Bereiche niedriger (22) Ladungsträgerinjektion strukturiert ist, wobei der Flächenanteil der Bereiche hoher (21) Ladungsträgerinjektion mit größer werdendem Abstand zur Längsmittelachse (23) hin zunimmt.

9. Kantenemittierender Halbleiterlaserchip nach zumindest einem der vorherigen Ansprüche,
bei dem der Flächenanteil der Bereiche hoher (21) Ladungsträgerinjektion mit geringer werdendem Abstand zur Längsmittelachse (23) sowie mit kleiner werdendem Abstand zur der Seite des Halbleiterlaserchips (1) hin abnimmt, an der sich eine Auskoppelfacette (3) des Halbleiterlaserchips (1) befindet.

10. Kantenemittierender Halbleiterlaserchip nach zumindest einem der vorherigen Ansprüche,
bei dem der Kontaktstreifen (2) in einer Richtung quer zur Längsmittelachse (23) des Kontaktstreifens (2) sowie in einer Richtung parallel zur Längsmittelachse (23) des Kontaktstreifens (2) in Bereiche hoher (21) und Bereiche niedriger (22) Ladungsträgerinjektion strukturiert ist.

11. Kantenemittierender Halbleiterlaserchip nach zumindest einem der vorherigen Ansprüche,
bei dem der Kontaktstreifen (2) in Bereichen hoher (21) Ladungsträgerinjektion aus einem ersten Metall besteht und in Bereichen niedriger (22) Ladungsträgerinjektion aus einem zweiten Metall besteht, wobei der elektrische Übergangswiderstand zum Halbleitermaterial, auf das der Kontaktstreifen aufgebracht ist, des ersten Metalls kleiner ist als des zweiten Metalls.

## Claims

1. Edge-emitting semiconductor laser chip (1) having
- an active zone (14) in which electromagnetic radiation is generated during operation of the semiconductor laser chip (1),
- at least one contact strip (2), wherein the contact strip (2) has a width B,
- at least two current barriers (4) arranged on different sides of the contact strip (2) and extending along the contact strip (2), wherein the maximum distance V between each of the two current barriers (4) and the contact strip (2) is selected such that the ratio of maximum distance V to width B is V/B > 1.0, wherein
- the current barriers (4) extend to the active zone (14), wherein the current barriers (4) prevent a lateral current spreading, such that the electrical current which is impressed by means of the at least one contact strip (2) does not spread in such a way that the entire active zone (14) is current-supplied, but only a specific predefinable section of the active zone is supplied with the current, and
- the distance of at least one current barrier (4) from the contact strip (2) increases with decreasing distance to the side on which an output facet (3) of the semiconductor laser chip (1) is located.

2. Edge-emitting semiconductor laser chip according to the preceding claim,
in which the largest distance V is located near the side of the semiconductor laser chip (1) at which an output facet (3) of the semiconductor laser chip (1) is located.

3. Edge-emitting semiconductor laser chip according to at least one of the preceding claims,
in which the current barriers (4) are arranged axially symmetrical to the longitudinal central axis (23) of the contact strip (2).

4. Edge-emitting semiconductor laser chip according to at least one of the preceding claims,
in which the path of at least one of the current barriers (4) is step-shaped at least in places in a plane parallel to the extension plane of the contact strip (2).

5. Edge-emitting semiconductor laser chip according to at least one of the preceding claims with
at least two contact strips (2).

6. Edge-emitting semiconductor laser chip according to at least one of the preceding claims having at least one structured contact strip (2) which is structured such that an injection of charge carriers into the active zone (14) decreases towards one side of the semiconductor laser chip (1) on which the output facet (3) of the semiconductor laser chip (1) is located, wherein the contact strip (2) is structured in regions of high (21) and regions of low (22) charge carrier injection.

7. Edge-emitting semiconductor laser chip according to the preceding claim,
in which the area fraction of the regions of high (21) charge carrier injection decreases with decreasing distance to the side of the semiconductor laser chip at which an output facet (3) of the semiconductor laser chip (1) is located.

8. Edge-emitting semiconductor laser chip according to at least one of the preceding claims,
in which the contact strip (2) is structured in a direction transverse to the longitudinal central axis (23) of the contact strip (2) in regions of high (21) and regions of low (22) charge carrier injection, the area fraction of the regions of high (21) charge carrier injection increasing with increasing distance from the longitudinal central axis (23).

9. Edge-emitting semiconductor laser chip according to at least one of the preceding claims,
in which the area fraction of the regions of high (21) charge carrier injection decreases with decreasing distance to the longitudinal central axis (23) and with decreasing distance to the side of the semiconductor laser chip (1) at which an output facet (3) of the semiconductor laser chip (1) is located.

10. Edge-emitting semiconductor laser chip according to at least one of the preceding claims,
in which the contact strip (2) is structured in a direction transverse to the longitudinal central axis (23) of the contact strip (2) and in a direction parallel to the longitudinal central axis (23) of the contact strip (2) in regions of high (21) and low (22) charge carrier injection.

11. Edge-emitting semiconductor laser chip according to at least one of the preceding claims,
in which the contact strip (2) consists of a first metal in regions of high (21) charge carrier injection and consists of a second metal in regions of low (22) charge carrier injection, wherein the electrical contact resistance to the semiconductor material, to which the contact strip is applied, of the first metal is smaller than that of the second metal.

## Revendications

1. Puce laser à semi-conducteur (1) à émission par la tranche, comprenant
- une zone active (14) dans laquelle un rayonnement électromagnétique est généré pendant le fonctionnement de la puce laser à semi-conducteur (1),
- au moins une bande de contact (2), la bande de contact présentant une largeur B,
- au moins deux barrières de courant (4) qui sont disposées sur différents côtés de la bande de contact (2) et s'étendent le long de la bande de contact (2), le plus grand écart V entre chacune des deux barrières de courant (4) et la bande de contact (2) étant sélectionné de manière à ce que le rapport du plus grand écart V et de la largeur B soit V/B > 1,0,
- les barrières de courant (4) s'étendant jusqu'à la zone active (14), les barrières de courant (4) empêchant un élargissement latéral du courant de sorte que le courant électrique appliqué au moyen de l'au moins une bande de contact (2) ne s'élargisse pas de façon à alimenter la totalité de la zone active (14) en courant, mais que seulement une partie déterminée pouvant être prédéfinie de la zone active soit alimentée en courant,
- l'écart d'au moins une barrière de courant (4) par rapport à la bande de contact (2) augmentant au fur et à mesure que l'écart par rapport au côté, sur lequel se trouve une facette de découplement (3) de la puce laser à semi-conducteur (1), diminue.

2. Puce laser à semi-conducteur à émission par la tranche selon la revendication précédente,
dans laquelle le plus grand écart V se trouve à proximité du côté de la puce laser à semi-conducteur (1), sur lequel se trouve une facette de découplement (3) de la puce laser à semi-conducteur (1).

3. Puce laser à semi-conducteur à émission par la tranche selon au moins l'une des revendications précédentes, dans laquelle les barrières de courant (4) sont disposées avec symétrie d'axe par rapport à l'axe longitudinal médian (23) de la bande de contact (2).

4. Puce laser à semi-conducteur à émission par la tranche selon au moins l'une des revendications précédentes, dans laquelle l'allure d'au moins une des barrières de courant (4) est au moins en partie en forme d'étage dans un plan parallèlement au plan d'étendue de la bande de contact (2).

5. Puce laser à semi-conducteur à émission par la tranche selon au moins l'une des revendications précédentes, comprenant au moins deux bandes de contact (2).

6. Puce laser à semi-conducteur à émission par la tranche selon au moins l'une des revendications précédentes, comprenant au moins une bande de contact (2) structurée, laquelle est structurée de manière à ce qu'une injection de porteur de charge dans la zone active (14) diminue en direction d'un côté de la puce laser à semi-conducteur (1), sur lequel se trouve la facette de découplement (3) de la puce laser à semi-conducteur (1), la bande de contact (2) étant structurée en zones d'injection de porteur de charge élevées (21) et en zones d'injection de porteur de charge basses (22).

7. Puce laser à semi-conducteur à émission par la tranche selon la revendication précédente,
dans laquelle la fraction de surface des zones d'injection de porteur de charge élevées (21) diminue quand l'écart devient plus petit en direction du côté de la puce laser à semi-conducteur, sur lequel se trouve une facette de découplement (3) de la puce laser à semi-conducteur (1).

8. Puce laser à semi-conducteur à émission par la tranche selon au moins l'une des revendications précédentes, dans laquelle la bande de contact (2) est structurée en zones d'injection de porteur de charge élevées (21) et en zones d'injection de porteur de charge basses (22) dans une direction transversalement à l'axe longitudinal médian (23) de la bande de contact (2), la fraction de surface des zones d'injection de porteur de charge élevées augmentant lorsque l'écart par rapport à l'axe longitudinal médian (23) augment.

9. Puce laser à semi-conducteur à émission par la tranche selon au moins l'une des revendications précédentes, dans laquelle la fraction de surface des zones d'injection de porteur de charge élevées (21) diminue lorsque l'écart par rapport à l'axe longitudinal médian (23) devient plus petit et lorsque l'écart en direction du côté de la puce laser à semi-conducteur (1) devient plus petit, sur lequel se trouve une facette de découplement (3) de la puce laser à semi-conducteur (1).

10. Puce laser à semi-conducteur à émission par la tranche selon au moins l'une des revendications précédentes, dans laquelle la bande de contact (2) est structurée en zones d'injection de porteur de charge élevées (21) et en zones d'injection de porteur de charge basses (22), dans une direction transversalement à l'axe longitudinal médian (23) de la bande de contact (2) ainsi que dans une direction parallèlement à l'axe longitudinal médian (23) de la bande de contact (2)

11. Puce laser à semi-conducteur à émission par la tranche selon au moins l'une des revendications précédentes, dans laquelle la bande de contact (2) dans des zones d'injection de porteur de charge élevées (21) consiste en un premier métal et, dans des zones d'injection de porteur de charge basses (22), consiste en un deuxième métal, la résistance de contact électrique par rapport à la matière semi-conductrice, sur laquelle la bande de contact est appliquée, du premier métal étant inférieure à celle du deuxième métal.
